# EUROPÄISCHE PATENTSCHRIFT

(11) **EP 1 335 878 B1**
(45) Veröffentlichungstag und Bekanntmachung des Hinweises auf die Patenterteilung: **18.02.2009**
(21) Anmeldenummer: 01993579.0
(22) Anmeldetag: 10.10.2001
(51) Int. Cl.: B81B 7/00

(54) **MIKROSTRUKTURBAUELEMENT**
MICROSTRUCTURE COMPONENT
COMPOSANT A MICROSTRUCTURE

(30) Priorität: 07.11.2000 DE 10055081
(43) Veröffentlichungstag der Anmeldung: 20.08.2003
(73) Patentinhaber: ROBERT BOSCH GMBH, 70442 Stuttgart (DE)
(72) Erfinder: LAERMER, Franz, 71263 Weil der Stadt (DE)
(86) Internationale Anmeldenummer: PCT/DE2001/003882
(87) Internationale Veröffentlichungsnummer: WO 2002/038492

(56) Entgegenhaltungen:
- EP-A- 0 136 249
- EP-A- 0 962 275
- EP-A- 0 994 330
- ESASHI M ET AL: "Anodic bonding for integrated capacitive sensors" MICRO ELECTRO MECHANICAL SYSTEMS, 1992, MEMS '92, PROCEEDINGS. AN INVESTIGATION OF MICRO STRUCTURES, SENSORS, ACTUATORS, MACHINES AND ROBOT. IEEE TRAVEMUNDE, GERMANY 4-7 FEB. 1992, NEW YORK, NY, USA,IEEE, US, 4. Februar 1992 (1992-02-04), Seiten 43-48, XP010057236 ISBN: 0-7803-0497-7
- HENMI H ET AL: "VACUUM PACKAGING FOR MICROSENSORS BY GLASS-SILICON ANODIC BONDING" SENSORS AND ACTUATORS A, ELSEVIER SEQUOIA S.A., LAUSANNE, CH, Bd. A43, Nr. 1/3, 1. Mai 1994 (1994-05-01), Seiten 243-248, XP000454118 ISSN: 0924-4247
- UEDA M ET AL: "DEVELOPMENT OF MICROMACHINED SILICON ACCELEROMETER" SUMITOMO ELECTRIC TECHNICAL REVIEW, OSAKA, JP, Nr. 38, 1. Juni 1994 (1994-06-01), Seiten 72-77, XP000567200 ISSN: 0376-1207

## Beschreibung

Die Erfindung betrifft ein Mikrostrukturbauelement, insbesondere ein verkapptes mikromechanisches Sensorelement, nach der Gattung des Hauptanspruches.

### Stand der Technik

Aus US 5,756,901 ist ein in Oberflächenmikromechanik hergestellter Beschleunigungssensor und ein Schichtsystem zur Herstellung eines solchen Sensors bekannt, der zum Schutz vor äußeren Einflüssen wie Feuchtigkeit oder Schmutzpartikeln sowie auch zur Aufrechterhaltung eines Vakuums mit einer Kappe versehen ist. Weiter ist auch aus DE 195 37 814 A1 ein Sensor und ein Verfahren zu dessen Herstellung bekannt, bei dem aus einer Siliziumschicht ein bewegliches Sensorelement mit Hilfe oberflächenmikromechanischer Verfahren herausstrukturiert worden ist.

Ein bekanntes, beispielsweise in DE 195 37 814 A1 beschriebenes Verfahren zu Verkappung von Sensorelementen ist das sogenannte "Bonden" von Siliziumkappen durch eine Seal-Glas-Lotverbindung, was jedoch aufgrund des Fließverhaltens des Lots große Flächenvorhalte erfordert. Alternative, platzsparendere Verfahren ohne Flächenvorhalte beruhen auf einem sogenannten "anodischen Bondprozess" wobei Pyrex-Glas oder ein ähnliches Glas mit einer Siliziumschicht verbunden wird, indem eine elektrische Spannung von 1000 V oder mehr bei einer Temperatur von beispielsweise 400°C angelegt wird, so dass durch eine Ladungstrennung im Glas (Na⁺-Ionen bzw. O²⁻-Ionen) nach einer zunächst reversiblen Adhäsionsphase eine hochfeste Verbindung zwischen Pyrex und Silizium entsteht.

Im Einzelnen ist es bei einem derartigen anodischen Bonden einer Kappe bzw. einer Platte aus Pyrex-Glas über oberflächenmikromechanischen Sensorstrukturen üblich, diese zunächst so vorzustrukturieren, dass sie im Bereich der Sensorstrukturen eine Ausnehmung aufweist, und sie anschließend mit dem Silizium, aus dem die Sensorstruktren herausstrukturiert worden sind, hermetisch dicht zu verbinden. Dabei tritt jedoch das Problem auf, dass durch die hohe angelegte elektrische Spannung die freitragenden bzw. beweglichen Sensorstrukturen elektrostatisch ausgelenkt werden, und teilweise mit der Glasplatte verkleben. Diese Gefahr wird weiter dadurch verstärkt, dass Pyrex-Glas gute Adhäsionseigenschaften gegenüber Silizium zeigt und auf seiner Oberfläche elektrische Ladungen speichert, die auch ohne äußere Einwirkung Kräfte auf die Sensorstrukturen ausüben und damit deren Funktion beeinträchtigen. Im Übrigen sind für einen häufig gewünschten Vorderseitenkontakt der Sensorstrukturen Durchgangsöffnungen in der Kappe vorzusehen.

Wird andererseits die Ausnehmung so stark vertieft, dass die elektrostatische Anziehung auf ein tragbares Maß reduziert ist, so kann eine solche Kappe nicht mehr gleichzeitig als oberer Anschlag zum Schutz der erzeugten mikromechanischen Strukturen dienen, d.h. diese werden im Überlastfall, beispielsweise bei mechanischen Schocks bei Beschleunigungssensorstrukturen, nach oben unbehindert soweit ausgelenkt, bis sie zerstört sind. Im Übrigen ist eine Strukturierung von Pyrex-Glas problematisch, wenn Ätztiefen von einigen 10 µm erforderlich sind.

Nachteilig beim Verkappen durch anodisches Bonden von Pyrex-Glas auf Silizium ist weiter, dass dabei aus offenen Glasflächen Sauerstoff freigesetzt wird, so dass in der Praxis niedrigste Drükke von ca. 100 mbar unter solchen Kappen einschließbar sind, was bei in Oberflächenmikromechanik hergestellten Drehratensensoren bei Weitem nicht ausreichend ist, die im Allgemeinen Arbeitsdrücke um 1 mbar benötigen. Zur Überwindung dieses Problems wurde bereits vorgeschlagen, Gettermaterialien einzusetzen, die Sauerstoff in der von der Kappe gebildeten Kaverne binden. Dieses Vorgehen ist jedoch teuer und prozesstechnisch aufwendig.

Schließlich ist beim Verkappen von Mikrostrukturbauelementen bekannt, einen Siliziumwafer als Kappenwafer einzusetzen, der oberflächlich mit einer Glasschicht, beispielsweise einer Pyrex-Glasschicht, versehen ist. Diese wird dann auf eine gewünschte Dicke abgeschliffen, poliert und schließlich mit einer Strukturierung in Form einer Kaverne als Kappe für das Sensorelement versehen. Insgesamt wird damit einerseits der Austritt von Sauerstoff in das Kaverneninnere reduziert, und andererseits kann der die eigentliche Kappe bildende, elektrisch leitende Siliziumwafer, wenn auch verfahrenstechnisch aufwendig, elektrisch kontaktiert werden, was der Gefahr elektrostatischer Aufladung vorbeugt. Auch in dieser Ausführungsform ist aber die Gefahr des elektrostatischen Kollaps und eines Verklebens der verkappten mikrostrukturierten Sensorelemente mit der Pyrex-Glasschicht oder einem freiliegenden Siliziumbereich am Boden der Kaverne in der Pyrex-Glassschicht weiterhin gegeben. Zudem kann auch in diesem Fall die Kappe vielfach nicht als Anschlag zur Begrenzung einer vertikalen Auslenkung der verkappten Mikrostrukturen im Überlastfall dienen, da infolge relativ hoher Toleranzen beim Schleifen und Polieren, die Dicke der Pyrex-Glasschicht, die den Abstand des Kavernenbodens von Mikrostruktur bestimmt, zu groß ist, um die Auslenkung wirksam zu begrenzen, oder andererseits zu klein ist, um beim anodischen Bonden einen elektrostatischen Kollaps ausschließen zu können. Zudem stellt das Zurückschleifen der Pyrex-Schicht mit hoher Präzision einen erheblichen Kostenfaktor dar, wobei man stets mit Restdickentoleranz von +/- 5 µm rechnen muss. Insofern muss die Restdicke dieser Schicht auf mindestens 20 µm ausgelegt sein, was sie als Anschlag wirkungslos macht. Überdies ist die Strukturierung von ca. 20 µm dicken Pyrex-Glasschichten durch Plasmen oder Flusssäurelösungen aufwendig und zeitintensiv.

In der Schrift "Development of Micromachined Silicon Accelerometer", Sumimoto electrical technical review, Nr. 38, Juni 1994, Seiten 72-77, wird ein mikromechanisches Bauelement beschrieben, das ein Drei-Schicht-System aus Glas-Silizium-Glas aufweist, die miteinander durch anodisches Bonden verbunden sind. Dabei ist eine bewegliche Elektrode aus Silizium zwischen einer oberen und einer unteren, jeweils auf einem Glasträger aufgebrachten festen Aluminium-Elektroden angeordnet, so dass die bewegliche Elektrode zusammen mit den beiden festen Elektroden jeweils eine erste bzw. eine zweite Kapazität bildet. Aus einer Änderung der Kapazitäten wird ein Sensorsignal abgeleitet. Zur elektrischen Kontaktierung ist die obere Elektrode über eine Durchführung aus Silizium mit einer Kontaktfläche verbunden. Die Kontaktfläche wird, ebenso wie die Kontaktflächen der anderen beiden Elektroden, aus einer Aluminiumschicht auf der Oberseite des unteren Glasträgers gebildet. Um einen freien Zugang zu den Kontaktflächen zu ermöglichen, ist die Länge des oberen Glasträgers kürzer als die des unteren Glasträgers, und zudem ist die mittlere Siliziumschicht in den entsprechenden Bereichen oberhalb der Kontaktflächen entfernt worden.

Weiter ist aus der Schrift "Anodic bonding for integrated capacitive sensors", Micro Electro Mechanical Systems, Proceedings, Travemünde, Germany, Februar 1994, Seiten 43-48, ein Verfahren zum anodisches Bonden in Anwendung für einen kapazitiven Sensor bekannt. Dabei wird ein Mikrostrukturbauelement mit einem Pyrex-Glaskörper durch anodisches Bonden verkappt, wobei dort ein die Mikrostruktur überdeckender Bereich des Glaskörpers auf seiner der Mikrostruktur zugewandten Seite eine elektrisch leitfähige Beschichtung aus Aluminium oder Titan-Platin-Legierung aufweist. Auch auf seiner der Mikrostruktur abgewandten Seite kann eine Metallschicht, z. B. eine Aluminiumschicht, als eine Kontaktfläche aufgebracht werden. Eine Kontaktfläche, die einen elektrischen Zugang von der Rückseite des Sensors ermöglicht, ist nicht vorgesehen.

### Vorteile der Erfindung

Das erfindungsgemäße Mikrostrukturbauelement mit den Merkmalen des Anspruchs 1 hat den Vorteil, dass damit eine sichere, hermetisch dichte und zuverlässige Verkappung von insbesondere in Oberflächenmikromechanik hergestellten Sensorelementen gegeben ist, ohne dass die Gefahr eines elektrostatischen Kollaps durch übermäßige Auslenkung in Richtung auf den Glaskörper besteht. Insofern kann eine bei der Verbindung von Glaskörper mit beispielsweise einer Siliziumschicht angelegte elektrische Spannung frei gewählt werden, ohne Rücksicht auf die Mikrostrukturen nehmen zu müssen, da diese erfindungsgemäß allseitig vor unerwünschten elektrischen Feldern abgeschirmt sind.

Daneben ist auch eine elektrostatische Aufladung der Kappeninnenseite während des Betriebs des Mikrostrukturbauelementes ausgeschlossen, und es ist vorteilhaft möglich, das Kappeninnere auf ein definiertes Potential zu legen bzw. die elektrisch leitfähige Beschichtung im Kappeninneren von außen ohne wesentlichen Aufwand elektrisch zu kontaktieren.

Weiter ist vorteilhaft, dass ein Austritt von Sauerstoff aus dem Glaskörper auf seiner den Mikrostrukturen zugewandten Seite durch die Beschichtung verhindert wird, und dass auch ein hochpräziser Schleifprozess oder eine tiefe Strukturierung des Glaskörpers entfallen kann. Zudem kann der Glaskörper nun ohne Zusatzkosten gleichzeitig die Funktion eines vertikalen Anschlags zur Begrenzung der vertikalen Auslenkung der Mikrostrukturen im Überlastfall übernehmen, d.h. es wird eine Verkappung erzielt, die die Vorteile der anodischen Bondtechnik mit einer Anschlagsfunktion verbindet, und die einen relevanten Sauerstoffaustritt aus dem Glaskörper ausschließt. Die aufgebrachte elektrisch leitfähige Beschichtung wirkt somit sehr vorteilhaft auch als Versiegelung und als Diffusionssperre für Sauerstoffionen, so dass auch niedrige Drücke von beispielsweise 1 mbar, wie sie für Drehratensensoren erforderlich sind, ohne zusätzliche Maßnahmen wie das erläuterte Einbringen von Gettermaterialien über lange Zeiten in dem verkappten Mikrostrukturbauelement aufrecht erhalten werden können.

Vorteilhafte Weiterbildungen der Erfindung ergeben sich aus den in den Unteransprüchen genannten Maßnahmen.

So ist vorteilhaft, wenn auch die der Mikrostruktur abgewandte Seite des Glaskörpers, d.h. die Außenseite der Kappe, eine elektrisch leitfähige Schicht aufweist, da sich dann die beim Bonden angelegte elektrische Spannung homogen über die gesamte Oberfläche des Glaskörpers verteilt. Zudem erlaubt diese Schicht bei späteren Rückseiten-Strukturierungsprozessen der Siliziumschicht, aus der die jeweiligen Mikrostrukturen bevorzugt herausstrukturiert sind, ein elektrostatisches Halten des Siliziumwafers in einer Plasma-Ätzanlage. Überdies ist vorteilhaft, dass diese Schicht auch erst in einem späteren Prozessstadium, beispielsweise unmittelbar vor der Durchführung einer Rückseitenätzung, aufgebracht werden kann.

Weiter ist vorteilhaft, dass bei dem Verbinden des Glaskörpers mit der Siliziumschicht, das bei erhöhten Temperatur von beispielsweise 400°C erfolgt, zumindest partiell eine Legierung zwischen der auf der Innenseite der Kappe bzw. des Glaskörpers aufgebrachten Beschichtung aus Metall und dem Silizium gebildet wird, was zu einem besonders guten ohm`schen Kontakt mit niedrigem Übergangswiderstand zwischen der Metallbeschichtung und dem Silizium in den Randbereichen führt. Auf diese Weise werden zudem die eingeschlossenen Mikrostrukturen weiter gegen elektrische Felder und Ladungen abgeschirmt.

Im Fall einer Metallschicht als elektrisch leitfähige Beschichtung ist vorteilhaft, dass diese geringe Adhäsionskräfte auf Silizium ausübt und damit eine geringe Klebeneigung zeigt. Zudem können dadurch, dass diese Metallschicht elektrisch an das Siliziumsubstrat angebunden bzw. über eine separate Kontaktfläche von außen zugänglich ist, Spannungsdifferenzen zwischen den Mikrostrukturen und der Kappenunterseite, d.h. der Metallschicht, wirksam unterdrückt oder für spezielle Anwendungen definiert eingestellt werden. Eine solche Spannungsunterdrückung kann vorteilhaft dadurch erfolgen, dass die Metallbeschichtung des Glaskörpers auf dessen Innenseite dynamisch mit dem Potential der Mikrostrukturen mitgeführt wird.

Sofern zunächst eine Kaverne in dem Glaskörper oberhalb des von den Mikrostrukturen eingenommenen Bereiches erzeugt und anschließend die elektrisch leitfähige Beschichtung, beispielsweise in Form einer Metallschicht, auf den Glaskörper und die Innenseiten der Kaverne aufgebracht worden ist, ergibt sich die Möglichkeit, anstelle eines Fotoprozesses und eines anschließenden Ätzens zur Strukturierung der Metallbeschichtung den beispielsweise als Pyrex-Glasplatte vorliegenden Glaskörper einfach abzupolieren, und ihn damit flächig von überstehendem Metall zu befreien. Dadurch entsteht vorteilhaft in dem Rand- oder Kantenbereich der Kaverne ein planarer Übergang von Glas auf Metall.

In diesem Fall ist zudem vorteilhaft, wenn die Metallschicht deutlich dicker, beispielsweise 0,5 µm bis 5 µm dick ausgeführt ist, da dies in dem Randbereich, d.h. dem durch das Polieren erzeugten planaren Übergang, zu einem größeren und verbesserten Überlapp von Metall und Silizium führt. In diesem Überlapp entsteht dann bei dem nachfolgenden anodischen Bonden zumindest punktuell eine Metall-Silizium-Legierung, was einen besonders guten elektrischen Kontakt der Metallschicht mit der Siliziumschicht gewährleistet. Diese Vorgehensweise hat zudem den Vorteil, dass auf der Glasschicht keine das Bonden beeinträchtigenden Topografieunterschiede auftreten. Zudem führt die dickere Metallschicht zu einer weiter verbesserten elektrischen Abschirmung und Diffusionssperrwirkung.

In dem Fall, dass der Glaskörper als dünne Glasschicht ausgeführt ist, die auf ihrer der Mikrostruktur abgewandten Seite mit einem Tragkörper, vorzugsweise einer Siliziumschicht oder einem Siliziumwafer, verbunden ist, wird eine verbesserte Anpassung von Glaskörper und der Siliziumschicht hinsichtlich auftretender mechanischer Spannungen erreicht, da der mechanische Einfluss der Glasschicht aufgrund ihrer gegenüber einer freien Glasplatte deutlich reduzierten Dicke abnimmt.

Weiter ist in diesem Fall auch das Vereinzeln der Mikrostrukturbauelemente auf einem Wafer nach der Herstellung vereinfacht, da dies nunmehr durch Durchsägen des kompletten Schichtaufbaus in einem einzigen Sägeschritt erfolgen kann. Demgegenüber sind bei Verwendung einer dickeren Glasplatte ohne Tragkörper zwei Sägeschritte, einer für die Glasplatte und einer für das Substrat, d.h. den Siliziumwafer, erforderlich.

Im Übrigen sorgt der Tragkörper in Form eines Siliziumwafers für eine gegenüber einer Glasplatte homogenere Aufbringung der beim Bonden angelegten elektrischen Spannung, d.h. auf die bereits erläuterte zusätzliche Leitschicht auf der Außenseite der Kappe kann verzichtet werden. Schließlich ist in diesem Fall vorteilhaft, dass nur geringe Anforderungen an die Genauigkeit der Restschichtdicke nach einem Schleif- und Polierprozess gestellt werden müssen, was diesen relativ kostengünstig macht.

Insgesamt erkauft man sich somit den Vorteil des einfacheren und kostengünstigeren Sägeprozesses durch eine etwas aufwendigere Prozessierung der Glasschicht und des damit verbundenen Tragkörpers.

Zusammenfassend hat das Mikrostrukturbauelement den Vorteil, dass zu seiner Herstellung lediglich relativ einfache, leicht beherrschbare Strukturierungsprozesse erforderlich sind, und dass gleichzeitig eine erhebliche Reduktion des Verbrauchs an Chipfläche beim Verkappen erreicht wird. Weiter ist es zur Strukturierung des Glaskörpers mit einer Kaverne lediglich erforderlich, den Glaskörper einige µm tief zu ätzen, wozu auch Lackmasken einsetzbar sind.

### Zeichnungen

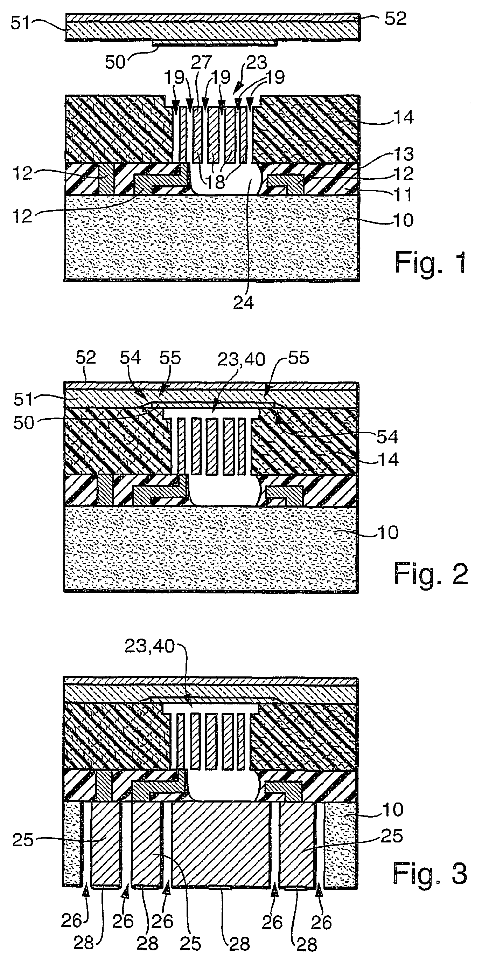

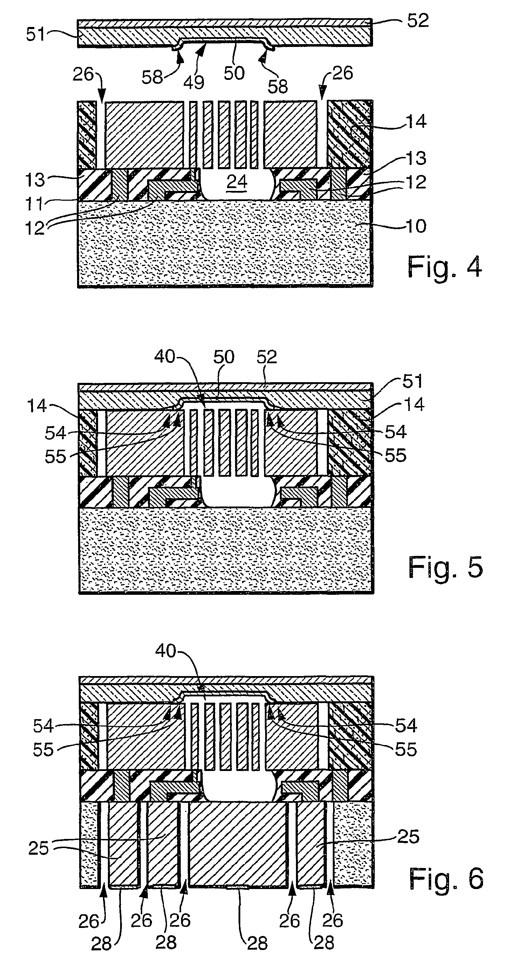

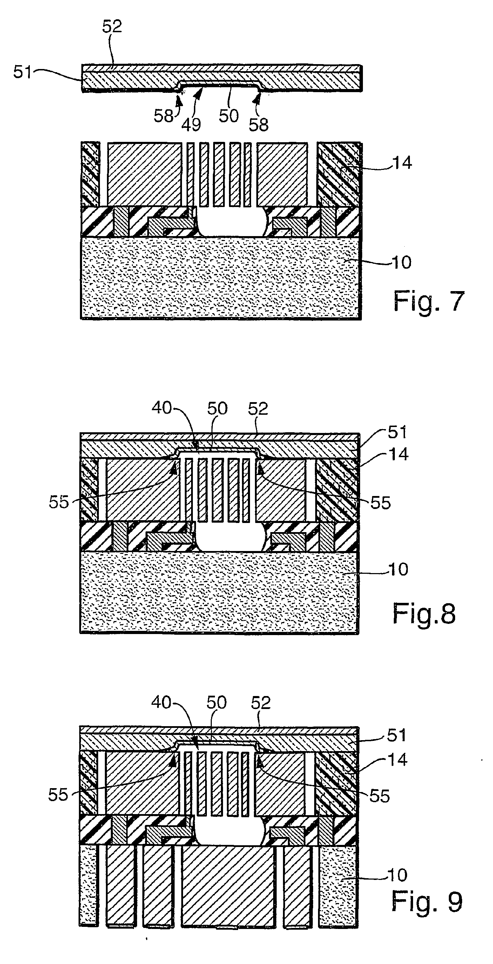

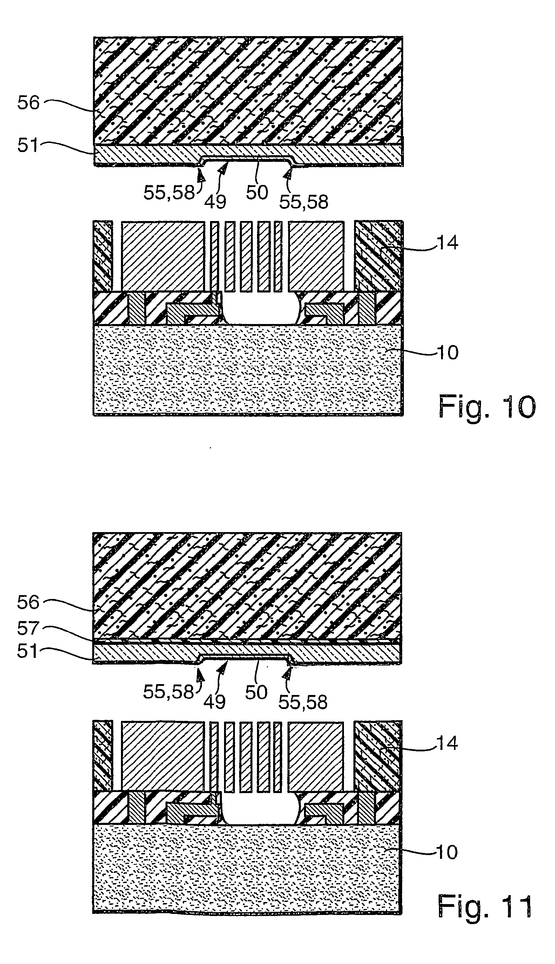

Die Erfindung wird anhand der Zeichnung und in der nachfolgenden Beschreibung näher erläutert. Es zeigen die Figuren 1 bis 3 Verfahrensschritte beim Verkappen eines Mikrostrukturbauelementes im Rahmen eines ersten Ausführungsbeispiels im Schnitt, die Figuren 4 bis 6 analoge Verfahrensschritte eines zweiten Ausführungsbeispiels, die Figuren 7 bis 9 analoge Verfahrensschritte eines dritten Ausführungsbeispiels, Figur 10 einen zu Figur 4 oder Figur 7 analogen Verfahrensschritt eines fünften und Figur 11 einen entsprechenden Verfahrensschritt eines sechsten Ausführungsbeispiels.

### Ausführungsbeispiele

Die Figuren 1 bis 3 erläutern ein erstes Ausführungsbeispiel eines Mikrostrukturbauelementes. Figur 1 zeigt zunächst einen Siliziumwafer als Substrat 10 im Schnitt, auf dem in bekannter Weise eine untere Isolationsschicht 11 aus einem Oxid bzw. Isolationsoxid aufgebracht worden ist. Auf der unteren Isolationsschicht 11 befindet sich weiter eine an sich bekannte Leitstruktur 12, die beispielsweise aus vergrabenem Polysilizium besteht. Auf der vergrabenen Leitstruktur 12 bzw. der unteren Isolationsschicht 11 ist dann analog der unteren Isolationsschicht 11 eine obere Isolationsschicht 13 aus einem Oxid bzw. einem Isolationsoxid abgeschieden, auf der wiederum eine Siliziumschicht 14 aus Polysilizium mit einer Dicke von 10 µm bis 100 µm abgeschieden ist. Das Substrat 10, die Leitstruktur 12 und die Siliziumschicht 14 sind vom gleichen Dotierungstyp, d.h. p-dotiert oder bevorzugt n-dotiert.

Aus der Siliziumschicht 14 sind weiter in bekannter Weise durch geeignete Maskierungen und Ätztechniken zumindest weitgehend freitragende Mikrostrukturen 18 herausstrukturiert worden, die über Gräben 19 voneinander getrennt sind. Insofern ist die Siliziumschicht 14 der "Bondrahmen" für die Mikrostrukturen 18. Weiter ist mindestens eine Mikrokontaktierungsstruktur 27 als Teil des Mikrostrukturbauelementes vorgesehen, die mit der Leitstruktur 12 elektrisch leitend verbunden ist, und über die die einzelnen Mikrostrukturen 18 elektrisch ansteuerbar sind. Unterhalb der Mikrostrukturen 18 ist eine erste Ausnehmung 24 vorgesehen, so dass die Mikrostrukturen 18 weitgehend freitragend in der Siliziumschicht 14 aufgehängt sind. Im Übrigen ist vorgesehen, dass die Mikrostrukturen 18 und die Mikrokontaktierungsstruktur 27 gegenüber der Siliziumschicht 14 in bekannter Weise rückgesetzt bzw. "versenkt" sind, so dass oberhalb von diesen eine zweite Ausnehmung 23 entsteht, die eine Tiefe von beispielsweise 5 µm bis 10 µm aufweist. Die einzelnen Verfahrensschritte zum Erzeugen des Mikrostrukturbauelementes gemäß Figur 1 sind, abgesehen von der nachfolgend erläuterten Verkappung, an sich aus der Herstellung von Beschleunigungssensoren bekannt. Insbesondere ist das Herstellen "versenkter" Strukturen in Oberflächenmikromechanik aus der Anmeldung DE 199 40 512.3 bekannt.

Die Figur 1 zeigt weiter eine Glasschicht 51, die in Form einer Pyrex-Glasplatte von beispielsweise 0,5 mm Dicke ausgebildet ist. Auf dieser Glasschicht 51 ist dann auf der den Mikrostrukturen 18 zugewandten Seite eine dünne Beschichtung 50 in Form einer Metallschicht aufgebracht und so strukturiert, dass sie den Bereich der zweiten Ausnehmung 23, d.h. insbesondere den von den Mikrostrukturen 18 und der Mikrokontaktierungsstruktur 27 eingenommenen Bereich, überdeckt und gleichzeitig umlaufend über die von der zweiten Ausnehmung 23 in Draufsicht eingenommene Fläche hinausgeht. Schließlich ist vorgesehen, dass die Glasschicht 51 auf ihrer den Mikrostrukturen 18 abgewandten Seite ganzflächig mit einer Leitschicht 52, beispielsweise mit einer Metallschicht, versehen ist. Diese Leitschicht 52 ist, wie bereits erläutert, teilweise vorteilhaft bei der weiteren Herstellung des Mikrostrukturbauelementes, jedoch nicht zwingend.

Die Figur 2 erläutert einen auf Figur 1 folgenden Verfahrensschritt, wobei die Glasschicht 51 mit der Beschichtung 50 und der Leitschicht 52 mit der Oberfläche der Siliziumschicht 14 in Kontakt gebracht worden ist. Danach wurde das Substrat 10 geerdet und eine elektrische Spannung zwischen der Glasschicht 51 und dem Substrat 10 von typischerweise 1000 V bei einer Temperatur von beispielsweise 400° angelegt. Dieses Verfahren, das als "anodisches Bonden" bezeichnet wird, führt zu einer innigen, hermetisch dichten Verbindung der Glasschicht 51 mit der Siliziumschicht 14.

Unter hermetisch dicht wird dabei eine Verbindung verstanden, die sowohl gasdicht als auch gegenüber Feuchtigkeit dicht ist.

Die Figur 2 zeigt weiter, dass sich durch das Verbinden von Glasschicht 51 und Siliziumschicht 14 die Beschichtung 50 in einem Randbereich 55 zwischen Glasschicht 51 und Siliziumschicht 14 befindet. Dieser Randbereich 55 ist in Draufsicht, je nach Form der zweiten Ausnehmung 23, beispielsweise ringförmig, bevorzugt jedoch in sich geschlossen.

Da die Beschichtung 50 im erläuterten Beispiel eine Dicke von 3 nm bis 100 nm, vorzugsweise 10 nm bis 50 nm, aufweist, verbleibt ein Taschenbereich 54 zwischen Glasschicht 51 und Siliziumschicht 14 nicht gebondet, d.h. in diesem Bereich ist die Siliziumschicht 14 nicht mit der Glasschicht 51 in Kontakt, wobei dessen Ausdehnung offensichtlich von der Dikke der Beschichtung 50 abhängt. Er erstreckt sich typischerweise über einen Bereich von 5 bis 10 mal der Dicke der Beschichtung 50.

Da es bei dem Verbinden der Glasschicht 51 mit der Siliziumschicht 14 auch zu einem innigen, insbesondere elektrisch leitfähigen Kontakt zwischen der Siliziumschicht 14 und der Beschichtung 50 kommt, ist die Beschichtung 50 während des gesamten Vorganges des anodischen Bondens ungeachtet der hohen angelegten elektrischen Spannung und auch nach Abschluss des Bondens auf das Potential der Siliziumschicht 14 und darüber des Substrates 10 fixiert, mit dem auch die Mikrostrukturen 18 über die Mikrokontaktierungsstruktur 27 und die Leitstruktur 12 in Verbindung stehen. Insofern werden die Mikrokontaktierungsstrukturen 18 durch die Beschichtung 50 wirksam gegenüber elektrischen Feldern und Ladungen abgeschirmt. Im Übrigen sei erwähnt, dass durch die geringe Dikke der Beschichtung 50 die Ausdehnung des Taschenbereiches 54 vernachlässigbar ist, und die erzielte Verkappung nicht nennenswert beeinträchtigt.

Insgesamt ist somit nach Abschluss des Verfahrensschrittes gemäß Figur 2 ein Hohlraum 40 oberhalb der Mikrostrukturen 18 entstanden, der eine Tiefe entsprechend der Höhe der Ausnehmung 23 aufweist.

Die Figur 3 erläutert die abschließenden Verfahrensschritte zur Fertigstellung des Mikrostrukturbauelementes, bei denen zur elektrischen Kontaktierung der Mikrokontaktierungsstruktur 27 bzw. darüber der Mikrostrukturen 18 von der Rückseite des Substrates 10 in üblicher Weise Isolationsgräben 26 eingeätzt werden, die in der Tiefe bis zu der unteren Isolationsschicht 11 reichen. Durch diese Isolationsgräben 26 werden Anschlusskontaktierungsstrukturen 25 definiert, die einerseits mit einer üblichen Metallisierung in Form von Kontaktflächen 28 versehen sind, und die andererseits mit den Leitstrukturen 12 in Verbindung stehen. Die Kontaktflächen 28 sind im erläuterten Beispiel Metallflächen, beispielsweise aus Aluminium, Aluminium-Silizium, Aluminium-Silizium-Kupfer, Chrom/Gold oder Wolfram-Titan/Gold. Im Übrigen ist, wie in Figur 3 angedeutet, die Beschichtung 50 über die Siliziumschicht 14 und eine Leitstruktur 12 bevorzugt ebenfalls über eine Anschlußkontaktierungsstruktur 25 und eine Kontaktfläche 28 elektrisch zugänglich. Dabei sei jedoch betont, dass bei geeigneter Perforierung der Glasschicht 51 analog DE 195 37 814 A1 alternativ auch eine elektrische Kontaktierung von der Vorderseite der Siliziumschicht 14 möglich ist. Dazu ist lediglich die Glasschicht 51 derart vorzustrukturieren, dass sie im Bereich ebenfalls vorderseitig angelegter Anschlussflächen der Mikrokontaktierungstruktur 27 bzw. der Mikrostrukturen 18 Durchstrittsöffnungen, sogenannte Kontaktlöcher, aufweist, durch die dann später die zwischen Siliziumschicht 14 und Glasschicht 51 befindlichen Anschlussflächen, beispielsweise mittels Draht-Bonden, kontaktiert werden können.

Weiter sei erwähnt, dass der Abstand der Mikrokontaktierungsstrukturen 18 von der Beschichtung 50 gemäß Figur 3 durch die Höhe des Hohlraums 40 gegeben ist, d.h. die Beschichtung 50 und die damit verbundene Glasschicht 51 wirken gleichzeitig als vertikaler Anschlag für die Mikrostrukturen 18 im Überlastfall. Zudem sei betont, dass zur Realisierung eines Drehratensensors der Herstellungsprozess des verkappten Mikrostrukturbauelementes derart erfolgt, dass der Hohlraum 40 ein Vakuum mit einem Druck von beispielsweise 1 mbar einschließt.

Als Materialien zur Herstellung der Beschichtung 50 in Form einer Metallschicht eignen sich vor allem Chrom, Aluminium, Gold, Platin, Titan, Silber oder Kombinationen oder Legierungen derselben.

Eine bevorzugte Ausführungsform sieht vor, dass die Beschichtung 50 zwei Teilschichten, eine Metallschicht und eine die Haftung auf der Glasschicht verbessernde Haftschicht, aufweist, wobei die Haftschicht bevorzugt eine Chromschicht, eine Wolfram-Titan-Schicht oder eine Chrom-Kupfer-Schicht ist und eine Dicke von lediglich einigen Nanometern aufweist. Eine solche Dicke ist ausreichend, da die Beschichtung 50 in der Regel keine Ströme trägt und lediglich elektrostatischen Aufladungen entgegentreten muss. Andererseits ist auf diese Weise gewährleistet, dass das eingesetzte anodische Bonden problemlos verläuft. So wird durch die Elastizität der Glasschicht 51 und die auftretenden anziehenden Oberflächenkräfte zwischen Glasschicht 51 und Siliziumschicht 14 eine gute Adhäsion trotz der durch die Beschichtung 50 hervorgerufene Topografie der Oberfläche der Glasschicht 51 erreicht.

Die Figuren 4 bis 6 erläutern ein zweites Ausführungsbeispiel, wobei die Mikrostrukturen 18 bzw. die Mikrokontaktierungsstruktur 27 gegenüber der Siliziumschicht 14 nicht rückgesetzt bzw. versenkt ist. Weiter ist in Figur 5 dargestellt, dass auch die Siliziumschicht 14 je nach Anwendungsfall Isolationsgräben 26 aufweisen kann, die in üblicher Weise analog den Gräben 19 erzeugt worden sind. Diese Isolationsgräben 26 dienen beispielsweise der elektrischen Trennung verschiedener Bereiche der Siliziumschicht 14.

Die Figur 4 zeigt, dass die Glasschicht 51 aus Pyrex-Glas in diesem Ausführungsbeispiel eine Kaverne 49 aufweist, die derart dimensioniert ist, dass sie den von den Mikrostrukturen 18 bzw. der Mikrokontaktierungsstruktur 27 eingenommenen Bereich in der Siliziumschicht 14 überdeckt. Die Kaverne 49 bildet somit nach dem Verbinden der Glasschicht 51 mit der Siliziumschicht 14 eine Kappe über den Mikrostrukturen 18, wodurch erneut ein Hohlraum 40 entsteht, d.h. die Kaverne 49 ersetzt das Versenken der Mikrostrukturen 18 gemäß Figur 1.

Im Einzelnen ist vorgesehen, dass die Kaverne 49 in der Glasschicht 51 eine Tiefe von wenigen Mikrometern, beispielsweise 1 µm bis 10 µm, aufweist, und dass auf die Glasschicht 51 im Bereich der Kaverne 49 und darüber hinaus in dem Randbereich 55 erneut eine Beschichtung 50 aufgebracht ist, die analog der Beschichtung gemäß dem ersten Ausführungsbeispiel ist. Insbesondere weist diese Beschichtung 50 eine Dicke von 10 nm bis 50 nm auf.

Da durch die Beschichtung 50 bei dem anodischen Bonden von Siliziumschicht 14 und Glasschicht 51 keine Rücksicht mehr auf elektrostatische Anziehungskräfte und Aufladungen genommen werden muss, genügt eine Tiefe der Kaverne 49 von wenigen Mikrometern, d.h. diese kann sowohl nasschemisch durch Ätzen mit einer Flusssäurelösung als auch trockenchemisch durch Ätzen mit reaktiven Fluorplasmen in die Glasschicht 51 eingeätzt worden sein.

Die Figur 4 zeigt zudem, dass die Kaverne 49 Seitenwandprofile aufweist, die sich nach innen, d.h. in Richtung auf den Kavernenboden hin, verengen. Dies erleichtert ein anschließendes Aufbringen der Beschichtung 50 auf die Seitenwände und den Boden der Kaverne 49 sowie auch auf den sich in die Glasschicht 51 erstreckenden Randbereich 55. Weiter ist wichtig, dass die Kaverne 49, die bevorzugt die Form einer Wanne hat, umlaufend einen verrundeten Rand 58 aufweist, der ebenfalls mit der Beschichtung 50 versehen ist.

Zur Herstellung der Kaverne 49 mit verrundetem Rand 58 können einerseits bekannte Plasmaätzprozesse eingesetzt werden. Andererseits eignen sich jedoch auch Nassätztechniken, da angesichts der geringen Ätztiefen von wenigen Mikrometern auch eine Fotolackmaskierung ausreichend ist.

Da weiter Flusssäure bekanntermaßen eine Fotolackmaskierung an Kanten unterkriecht, entsteht automatisch ein Profil der Kaverne 49, das in Richtung auf den Kavernenboden isotrop hinterschnitten ist, und das sich im Bereich des verrundeten Randes 58 flach nach außen zieht. Somit wird durch den isotropen Ätzcharakter einer Flusssäurelösung und das Unterkriechen bereits eine konkave Seitenwandfläche im oberen Teil der Kaverne 49 erhalten, die flach ausläuft.

Bevorzugt wird ein Plasmaätzen und ein Nassätzen miteinander kombiniert, da sich einerseits durch das Plasmaätzen zunächst in einfacher Weise ein sich in Richtung auf den Kavernenboden verengendes Seitenwandprofil realisieren lässt, und andererseits durch ein anschließendes Überätzen, beispielsweise mit einer Flusssäurelösung, das erläuterte Unterkriechen der Lackmaske die Kanten der Kaverne 49 beseitigt, so dass ein verrundeter Rand 58 entsteht, der flach ausläuft.

Auf diese Weise ist gewährleistet, dass die Kaverne 49 für eine nachfolgende Metallisierung bzw. ein nachfolgendes Aufbringen der Beschichtung 50 derart geformt ist, dass sich eine gleichmäßige Metallisierung an allen Stellen der Oberfläche der Kaverne 49 einstellt, ohne dass diese an scharfen Kanten abzureißen droht, was einen zuverlässigen elektrischen Kontakt zwischen der Beschichtung 50 und der Siliziumschicht 14 verhindern würde.

Die Beschichtung 50 gemäß Figur 4 wird im Übrigen wie auch im Fall der Figur 1 bevorzugt durch Aufsputtern aufgebracht.

Die Figur 5 erläutert einen weiteren Verfahrensschritt, bei dem die Glasschicht 51 mit der Kaverne 49 und der Beschichtung 50 mit der Oberfläche der Siliziumschicht 14 in Kontakt gebracht wird. Dabei ist wesentlich, dass die Kaverne 49 exakt oberhalb der Mikrostrukturen 18 platziert wird, so dass die Beschichtung 50 erneut in einem bevorzugt in sich geschlossenen, umlaufenden Randbereich 55 mit der Siliziumschicht 14 in Kontakt ist. Aufgrund der Höhe der Beschichtung 50 von 10 nm bis 50 nm entstehen gemäß Figur 5 analog zu Figur 2 Taschenbereiche 54, die jedoch nicht weiter störend sind.

Hinsichtlich der Justage der mit der Kaverne 49 versehenen Glasschicht 51 ist vorteilhaft, wenn die auf der den Mikrostrukturen 18 abgewandten Seite der Glasschicht 51 aufgebrachte Leitschicht 52 zunächst noch nicht vorhanden ist, da dann die Justage in einfacher Weise optisch durch die durchsichtige Glasschicht 51 erfolgen kann. Sofern die Leitschicht 52 bereits vorhanden ist, werden zur Justage beispielsweise Justage-Markierungen eingesetzt, die die relative Position von Glasschicht 51 und Siliziumschicht 14 zueinander definieren.

Da die Beschichtung 50 gemäß Figur 5 in einem Randbereich 55 über die Kaverne 49 hinausgeht, wird bei dem anodischen Bonden von Glasschicht 51 und Siliziumschicht 14, was analog dem ersten Ausführungsbeispiel erfolgt, die Beschichtung 50 in der Adhäsionsphase beim Bonden gegen die Siliziumschicht 14 gedrückt und damit elektrisch mit dieser kontaktiert.

Die Figur 6 erläutert analog zu Figur 3 wie die Rückseite des Substrates 10 mit Anschlusskontaktierungsstrukturen 25, Kontaktflächen 28 und Isolationsgräben 26 versehen wird. Dabei ist erneut vorgesehen, dass die Beschichtung 50 über die Siliziumschicht 14 und eine Leitstruktur 12 elektrisch leitend mit einer Anschlusskontaktierungsstruktur 25 verbunden ist, so dass beispielsweise das elektrische Potential der Beschichtung 50 dynamisch mit einem elektrischen Potential der Mikrostrukturen 18 mitgeführt werden kann. Auf diese Weise erhält man insgesamt ein hermetisch dicht verkapptes Mikrostrukturbauelement, das elektrisch gegenüber äußeren Feldern abgeschirmt ist. Gleichzeitig beschränkt die Höhe der Kaverne 49 die maximale Auslenkung der Mikrostrukturen 28 beispielsweise bei Überlast.

Die Figuren 7 bis 9 erläutern ein drittes Ausführungsbeispiel, das sich von dem zweiten Ausführungsbeispiel gemäß den Figuren 4 bis 6 lediglich dadurch unterscheidet, dass ausgehend von Figur 4 oder alternativ einer zunächst ganzflächigen Metallisierung der den Mikrostrukturen 18 zugewandten Seite der Glasschicht 51 mit der Kaverne 49 die Glasschicht 51 mit der Beschichtung 50 flächig abpoliert und somit, abgesehen von dem Bereich der Kaverne 49, von der Beschichtung 50 wieder befreit wird. Auf diese Weise entsteht automatisch ein planarer verrundeter Übergang von Glasschicht 51 in die Beschichtung 50 im Bereich des verrundeten Randes 58.

In Figur 7 ist weiter abweichend von Figur 4 vorgesehen, dass die Beschichtung 50 deutlich dicker, beispielsweise 0,5 bis 5 µm dick, gewählt ist, was dazu führt, dass bei einem Verbinden der Glasschicht 51 mit der Siliziumschicht 14 gemäß Figur 8 der Überlapp von Beschichtung 50 und Siliziumschicht 14 in den Randbereichen 55 vergrößert ist. Somit entsteht bei dem anodischen Bonden gemäß Figur 8 in den Randbereichen 55 zumindest punktuell eine Legierung aus dem Material der Beschichtung 50, d.h. einem Metall, mit dem Silizium aus der Siliziumschicht 14, was zu einem besonders guten elektrischen Kontakt zwischen Beschichtung 50 und Siliziumschicht 14 führt.

Der Vorteil des Ausführungsbeispiels gemäß den Figuren 7 bis 9 gegenüber dem Ausführungsbeispiel gemäß den Figuren 4 bis 6 liegt darin, dass keine die Verbindung von Siliziumschicht 14 und Glasschicht 51 beeinträchtigenden Topografieunterschiede auftreten, die zu der Ausbildung der Taschenbereiche 54 führen. Weiter kann und soll die Beschichtung 50 in dem dritten Ausführungsbeispiel vergleichsweise dick gewählt werden, das dies zu einer verbesserten elektrischen Abschirmung und einer verbesserten Diffusionssperrwirkung gegen den Austritt von Sauerstoff aus der Glasschicht 51 in den Hohlraum 40 führt. Die Fertigstellung des Mikrostrukturbauelementes gemäß Figur 9 entspricht der bereits erläuterten Figur 6.

Ein viertes, mit Hilfe der Figur 10 erläutertes Ausführungsbeispiel geht zunächst anstelle einer Glasschicht 51 in Form einer relativ dicken Pyrex-Glasplatte von einem Siliziumwafer bzw. einer Siliziumschicht 56 aus, auf der oberflächlich die Glasschicht 51 in Form einer dünnen Pyrex-Glasschicht aufgebracht ist, die eine Dicke von 1 µm bis 50 µm hat. Dazu wurde zunächst ein Plättchen oder ein Wafer aus Pyrex-Glas in bekannter Weise mit dem Siliziumwafer 56 verbunden und anschließend mechanisch zurückgeschliffen, so dass die Glasschicht 51 mit einer Schichtdicke von 20 µm bis 50 µm erhalten wurde. Alternativ kann das Aufbringen von Pyrex-Glas auf den Siliziumwafer 56 insbesondere in dem späteren Bondbereich jedoch auch durch Aufsputtern einer beispielsweise 1 µm dicken Pyrex-Schicht und nachträgliches Polieren erfolgen.

Da bei dem erläuterten Rückschleifen die erreichte Dicke der Glasschicht 51 kein kritischer Parameter ist und sie auch einen Gang über der Oberfläche des Siliziumwafers 56 aufweisen kann, ist das Rückschleifen ein relativ kostengünstiger Prozess ohne hohe Genauigkeitsanforderungen. Wesentlich ist lediglich, dass die Restschichtdicke der Glasschicht 51 deutlich größer als die Tiefe der nachfolgend erzeugten Kaverne 49 ist. Weiter ist wesentlich, dass bei dem Erzeugen der Kaverne 49 die Glasschicht 51 nicht bis auf den Siliziumwafer 56 durchgeätzt wird, d.h. es muss auch im Bereich der Kaverne 49 eine Dicke der Glasschicht 51 verbleiben, die eine hinreichende elektrische Isolation zwischen dem Siliziumwafer 56 und der schließlich erzeugten Beschichtung 50 gewährleistet. Das Ausführungsbeispiel gemäß Figur 10 ist im Übrigen völlig analog zu dem Ausführungsbeispiel gemäß den Figuren 7 bis 9.

Ein fünftes Ausführungsbeispiel, das mit Hilfe der Figur 11 erläutert wird, geht von dem Ausführungsbeispiel gemäß Figur 10 aus, wobei zwischen der Glasschicht 51 und dem Siliziumwafer 56 zusätzlich eine Isolationsschicht 57, beispielsweise aus einem thermisch erzeugten Siliziumoxid, vorgesehen ist. Diese Isolationsschicht 57 hat eine Dicke von 1 µm bis 2 µm und dient der elektrischen Isolation des Siliziumwafers 56 gegenüber der Glasschicht 51. Zur Erzeugung der Isolationsschicht 57 auf dem Siliziumwafer 56 ist vorgesehen, dass dieser zunächst thermisch oxidiert wird, und dass anschließend die Pyrex-Glasplatte vor dem Rückschleifen mit der thermisch oxidierten Oberfläche des Siliziumwafers 56 verbunden wird. Alternativ kann jedoch auch in diesem Fall die Glasschicht 51 zunächst aufgesputtert und anschließend poliert worden sein.

Durch die zusätzliche Isolationsschicht 57 wird gegenüber Figur 10 erreicht, dass selbst dann, wenn die Restschichtdicke der rückgeschliffenen Glasschicht 51 einmal kritisch dünn werden sollte, das Isolationsoxid immer noch eine ausreichende elektrische Durchschlagsfestigkeit gegenüber einer bei einem nachfolgenden anodischen Bonden der Glasschicht 51 mit der Siliziumschicht 14 angelegten elektrischen Spannung sicherstellt. Ansonsten entspricht das Ausführungsbeispiel gemäß Figur 11 dem bereits mit Hilfe der Figuren 7 bis 9 erläuterten Ausführungsbeispiel.

## Patentansprüche

1. Mikrostrukturbauelement, insbesondere verkapptes mikromechanisches Sensorelement, mit mindestens einer aus einer Schicht (14) herausstrukturierten Mikrostruktur (18), die mit einem Glaskörper (51), der mit der Schicht (14) durch anodisches Bonden verbunden ist, verkappt ist, wobei zumindest der die Mikrostruktur (18) überdeckende Bereich des Glaskörpers (51) auf seiner der Mikrostruktur (18) zugewandten Seite mit einer elektrisch leitfähigen Beschichtung (50) versehen ist, wobei die Beschichtung (50) sich über den die Mikrostruktur (18) überdeckenden Bereich des Glaskörpers (51) hinaus erstreckt und bereichsweise direkt mit der Schicht (14) verbunden ist, und wobei die Beschichtung (50) an der dem Glaskörper (51) abgewandten Seite der Schicht (14) über eine Leitstruktur (12) und eine Anschlußkontaktierungsstruktur (25) mit einer Kontaktfläche (28) verbunden ist, wobei die Kontaktfläche (28) auf der Unterseite der Anschlußkontaktierungsstruktur (25) angeordnet ist und die Schicht (14) sich auf einem Substrat (10, 12) befindet, **dadurch gekennzeichnet, dass** die Anschlußkontaktierungsstruktur (25) im Substrat (10) definiert ist.

2. Mikrostrukturbauelement nach Anspruch 1, **dadurch gekennzeichnet, dass** die Mikrostruktur (18) aus einer Schicht (14), insbesondere einer Siliziumschicht, herausstrukturiert ist, und dass der Glaskörper (51) bereichsweise mit der Schicht (14) verbunden ist.

3. Mikrostrukturbauelement nach Anspruch 1 oder 2, **dadurch gekennzeichnet, dass** die Beschichtung (50) mindestens eine Metallschicht, insbesondere eine Chromschicht, Aluminiumschicht, Goldschicht, Platinschicht, Nickelschicht, eine Silberschicht oder eine Kombination derselben, aufweist.

4. Mikrostrukturbauelement nach Anspruch 3, **dadurch gekennzeichnet, dass** die Beschichtung (50) neben der Metallschicht eine mit dem Glaskörper (51) verbundene Haftschicht, insbesondere eine Chromschicht, eine Wolfram-Titan-Schicht oder eine Chrom-Kupfer-Schicht, aufweist.

5. Mikrostrukturbauelement nach Anspruch 1, **dadurch gekennzeichnet, dass** die Beschichtung (50) eine Dicke von 3 nm bis 5 µm aufweist.

6. Mikrostrukturbauelement nach Anspruch 2, **dadurch gekennzeichnet, dass** die Beschichtung (50) sich über den die Mikrostruktur (18) überdeckenden Bereich des Glaskörpers (51) hinaus erstreckt und in einem insbesondere in sich geschlossenen Randbereich (55) elektrisch leitend mit der Schicht (14) verbunden ist.

7. Mikrostrukturbauelement nach Anspruch 6, **dadurch gekennzeichnet, dass** in dem Randbereich (55) zumindest bereichsweise oder punktuell eine Legierung aus dem Material der Beschichtung (50) mit dem Material der Schicht (14), insbesondere eine Metall-Silizium-Legierung, vorliegt.

8. Mikrostrukturbauelement nach einem der vorangehenden Ansprüche, **dadurch gekennzeichnet, dass** die Beschichtung (50) von außerhalb der verkappten Mikrostruktur (18) elektrisch kontaktierbar ist.

9. Mikrostrukturbauelement nach einem der vorangehenden Ansprüche, **dadurch gekennzeichnet, dass** der Glaskörper (51) eine 100 µm bis 2 mm dicke Glasplatte oder eine mit einem Tragkörper verbundene, 1 µm bis 100 µm dicke Glasschicht ist.

10. Mikrostrukturbauelement nach einem der vorangehenden Ansprüche, **dadurch gekennzeichnet, dass** der Glaskörper (51) aus einem ein Alkali-Element enthaltenden Glas, insbesondere Pyrex-Glas, besteht.

11. Mikrostrukturbauelement nach einem der vorangehenden Ansprüche, **dadurch gekennzeichnet, dass** der Glaskörper (51) auf seiner der Mikrostruktur (18) abgewandten Seite zumindest bereichsweise mit einer Leitschicht (52), insbesondere einer Metallschicht (52), versehen ist.

12. Mikrostrukturbauelement nach Anspruch 9, **dadurch gekennzeichnet, dass** der Tragkörper eine Siliziumschicht (56), insbesondere ein Siliziumwafer, oder eine Schichtanordnung mit einer Siliziumschicht (56) und einer die Glasschicht von der Siliziumschicht (56) trennenden Isolationsschicht (57) ist.

13. Mikrostrukturbauelement nach einem der vorangehenden Ansprüche, **dadurch gekennzeichnet, dass** zwischen der Mikrostruktur (18) und der Beschichtung (50) ein Hohlraum (40) eingeschlossen ist.

14. Mikrostrukturbauelement nach einem der vorangehenden Ansprüche, **dadurch gekennzeichnet, dass** die Mikrostruktur (18) mit dem Glaskörper (51) hermetisch dicht, insbesondere bei einem Druck von 10 mbar bis 0,1 mbar, verkappt ist.

15. Mikrostrukturbauelement nach einem der vorangehenden Ansprüche, **dadurch gekennzeichnet, dass** der Glaskörper (51) in dem die Mikrostruktur (18) überdeckenden Bereich eine Strukturierung, insbesondere eine Kaverne (49), aufweist, die oberflächlich mit der elektrisch leitfähigen Beschichtung (50) versehen ist.

16. Mikrostrukturbauelement nach einem der vorangehenden Ansprüche, **dadurch gekennzeichnet, dass** die Kaverne (49) eine Tiefe von 1 µm bis 20 µm aufweist.

17. Mikrostrukturbauelement nach einem der vorangehenden Ansprüche, **dadurch gekennzeichnet, dass** die Kaverne (49) wannenförmig ausgebildet ist und umlaufend einen verrundeten Rand (58) aufweist, der mit der elektrisch leitfähigen Beschichtung (50) versehen ist.

18. Mikrostrukturbauelement nach einem der vorangehenden Ansprüche, **dadurch gekennzeichnet, dass** die Kaverne (49) insbesondere allseitig derart schräg stehende oder gewölbte, mit der elektrisch leitfähigen Beschichtung (50) versehene Seitenwände aufweist, dass sich die Kaverne (49) in Richtung auf den Kavernenboden hin verjüngt.

## Claims

1. Microstructure component, in particular encapsulation micromechanical sensor element, having at least one microstructure (18) which is structured from a layer (14) and is encapsulated with a glass body (51) connected to the layer (14) by anodic bonding, wherein at least that region of the glass body (51) which covers the microstructure (18) is provided with an electrically conductive coating (50) on its side facing the microstructure (18), wherein the coating (50) extends beyond that region of the glass body (51) which covers the microstructure (18), and is directly connected to the layer (14) in regions, and wherein the coating (50), at that side of the layer (14) which is remote from the glass body (51), is connected to a contact area (28) via a conductive structure (12) and a connection contact-making structure (25), wherein the contact area (28) is arranged on the underside of the connection contact-making structure (25) and the layer (14) is situated on the substrate (10, 12), **characterized in that** the connection contact-making structure (25) is defined in the substrate (10).

2. Microstructure component according to Claim 1, **characterized in that** the microstructure (18) is structured from a layer (14), in particular a silicon layer, and **in that** the glass body (51) is connected to the layer (14) in regions.

3. Microstructure component according to Claim 1 or 2, **characterized in that** the coating (50) has at least one metal layer, in particular a chromium layer, aluminium layer, gold layer, platinum layer, nickel layer, a silver layer, or a combination thereof.

4. Microstructure component according to Claim 3, **characterized in that** the coating (50) has, alongside the metal layer, an adhesion layer connected to the glass body (51), in particular a chromium layer, a tungsten-titanium layer or a chromium-copper layer.

5. Microstructure component according to Claim 1, **characterized in that** the coating (50) has a thickness of 3 nm to 5 µm.

6. Microstructure component according to Claim 2, **characterized in that** the coating (50) extends beyond that region of the glass body (51) which covers the microstructure (18), and is electrically conductively connected to the layer (14) in an in particular self-contained edge region (55).

7. Microstructure component according to Claim 6, **characterized in that** an alloy of the material of the coating (50) with the material of the layer (14), in particular a metal-silicon alloy, is present at least in regions or at points in the edge region (55).

8. Microstructure component according to any of the preceding claims, **characterized in that** electrical contact can be made with the coating (50) from outside the encapsulated microstructure (18).

9. Microstructure component according to any of the preceding claims, **characterized in that** the glass body (51) is a 100 µm to 2 mm thick glass plate or a 1 µm to 100 µm thick glass layer connected to a carrying body.

10. Microstructure component according to any of the preceding claims, **characterized in that** the glass body (51) is composed of a glass containing an alkali element, in particular Pyrex glass.

11. Microstructure component according to any of the preceding claims, **characterized in that** the glass body (51), on its side remote from the microstructure (18), is provided with a conductive layer (52), in particular a metal layer (52), at least in regions.

12. Microstructure component according to Claim 9, **characterized in that** the carrying body is a silicon layer (56), in particular a silicon wafer, or a layer arrangement having a silicon layer (56) and an insulation layer (57) separating the glass layer from the silicon layer (56).

13. Microstructure component according to any of the preceding claims, **characterized in that** a void (40) is included between the microstructure (18) and the coating (50).

14. Microstructure component according to any of the preceding claims, **characterized in that** the microstructure (18) is encapsulated with the glass body (51) hermetically tightly, in particular at a pressure of 10 mbar to 0.1 mbar.

15. Microstructure component according to any of the preceding claims, **characterized in that** the glass body (51), in the region covering the microstructure (18), has a structuring, in particular a cavity (49) which is provided superficially with the electrically conductive coating (50).

16. Microstructure component according to any of the preceding claims, **characterized in that** the cavity (49) has a depth of 1 µm to 20 µm.

17. Microstructure component according to any of the preceding claims, **characterized in that** the cavity (49) is formed in trough-shaped fashion and has circumferentially a rounded edge (58) provided with the electrically conductive coating (50).

18. Microstructure component according to any of the preceding claims, **characterized in that** the cavity (49) has, in particular on all sides, oblique or curved side walls provided with the electrically conductive coating (50) such that the cavity (49) tapers in the direction of the bottom of the cavity.

## Revendications

1. Composant microstructuré, en particulier élément de détection micromécanique encapsulé, qui présente au moins une microstructure (18) structurée en relief dans une couche (14) et encapsulée par un corps en verre (51) relié à la couche (14) par liaison anodique,
au moins la partie du corps en verre (51) qui recouvre la microstructure (18) étant dotée sur son côté tourné vers la microstructure (18) d'un revêtement électriquement conducteur (50),
le revêtement (50) s'étendant au-delà de la partie du corps en verre (51) qui recouvre la microstructure (18) et certaines de ses parties étant reliées directement à la couche (14),
le revêtement (50) étant relié à une surface de contact (28) sur le côté de la couche (14) non tourné vers le corps en verre (51) par une structure conductrice (12) et une structure de contact de raccordement (25),
la surface de contact (28) étant disposée sur le côté inférieur de la structure de contact de raccordement (25) et la couche (14) étant située sur un substrat (10, 12),
**caractérisé en ce que**
la structure de contact de raccordement (25) est formée dans le substrat (10).

2. Composant microstructuré selon la revendication 1, **caractérisé en ce que** les microstructures (18) sont structurées en relief dans une couche (14), en particulier une couche de silicium, et **en ce que** certaines parties du corps en verre (51) sont reliées à la couche (14).

3. Composant microstructuré selon les revendications 1 ou 2, **caractérisé en ce que** le revêtement (50) présente au moins une couche métallique et en particulier une couche de chrome, une couche d'aluminium, une couche d'or, une couche de platine, une couche de nickel, une couche d'argent ou une de leurs combinaisons.

4. Composant microstructuré selon la revendication 3, **caractérisé en ce que** le revêtement (50) présente en plus de la couche métallique une couche d'adhérence reliée au corps en verre (51) et en particulier une couche de chrome, une couche de tungstène et de titane ou une couche de chrome et de cuivre.

5. Composant microstructuré selon la revendication 1, **caractérisé en ce que** le revêtement (50) a une épaisseur de 3 nm à 5 µm.

6. Composant microstructuré selon la revendication 2, **caractérisé en ce que** le revêtement (50) s'étend au-delà de la partie du corps en verre (51) qui recouvre la microstructure (18) et est relié de manière électriquement conductrice à la couche (14), notamment dans sa bordure fermée (55).

7. Composant microstructuré selon la revendication 6, **caractérisé en ce qu'**un alliage du matériau du revêtement (50) du matériau de la couche (14) et en particulier un alliage de métal et de silicium est prévu dans au moins certaines parties ou certains points de la bordure (55).

8. Composant microstructuré selon l'une des revendications précédentes, **caractérisé en ce que** le revêtement (50) peut être mis en contact électrique par l'extérieur de la microstructure encapsulée (18).

9. Composant microstructuré selon l'une des revendications précédentes, **caractérisé en ce que** le corps en verre (51) est une plaque de verre d'une épaisseur de 100 µm à 2 mm ou une couche de verre d'une épaisseur de 1 µm à 100 µm reliée à un corps de support.

10. Composant microstructuré selon l'une des revendications précédentes, **caractérisé en ce que** le corps en verre (51) est constitué d'un verre qui contient un élément alcalin et en particulier un verre pyrex.

11. Composant microstructuré selon l'une des revendications précédentes, **caractérisé en ce que** sur au moins certaines parties de son côté non tourné vers la microstructure (18), le corps en verre (51) est doté d'une couche conductrice (52) et en particulier d'une couche métallique (52).

12. Composant microstructuré selon la revendication 9, **caractérisé en ce que** le corps de support est une couche de silicium (56) et en particulier une galette de silicium, ou un système stratifié qui présente une couche de silicium (56) et une couche d'isolation (57) qui sépare la couche de verre de la couche de silicium (56).

13. Composant microstructuré selon l'une des revendications précédentes, **caractérisé en ce qu'**une cavité (40) est enfermée entre la microstructure (18) et le revêtement (50).

14. Composant microstructuré selon l'une des revendications précédentes, **caractérisé en ce que** la microstructure (18) est encapsulée de manière hermétique par le corps en verre (51), en particulier sous une pression de 10 mbar à 0,1 mbar.

15. Composant microstructuré selon l'une des revendications précédentes, **caractérisé en ce que** la partie du corps en verre (51) qui recouvre la microstructure (18) présente une structuration et en particulier une caverne (49) dont la surface est dotée du revêtement électriquement conducteur (50).

16. Composant microstructuré selon l'une des revendications précédentes, **caractérisé en ce que** la caverne (49) a une profondeur de 1 µm à 20 µm.

17. Composant microstructuré selon l'une des revendications précédentes, **caractérisé en ce que** la caverne (49) a la forme d'une cuvette et présente à sa périphérie un bord arrondi (58) qui est doté du revêtement électriquement conducteur (50).

18. Composant microstructuré selon l'une des revendications précédentes, **caractérisé en ce que** la caverne (49) présente en particulier sur tous ses côtés des parois latérales disposées obliquement ou bombées et dotées du revêtement électriquement conducteur (50), de telle sorte que la caverne (49) se rétrécit en direction du fond de la caverne.
